# EUROPÄISCHE PATENTSCHRIFT

(11) **EP 0 693 722 B1**
(45) Veröffentlichungstag und Bekanntmachung des Hinweises auf die Patenterteilung: **17.10.2001**
(21) Anmeldenummer: 95109079.4
(22) Anmeldetag: 13.06.1995
(51) Int. Cl.: G05F 1/56, G05F 1/30, H01J 37/24

(54) **Kathodenstromregler, insbesondere für einen Wanderfeldröhrenverstärker**
Cathode current regulator, in particular for an amplifier of a travelling-wave tube
Régulateur de courant de cathode, en particulier pour un amplificateur de tube à onde progressive

(30) Priorität: 21.07.1994 DE 4425841
(43) Veröffentlichungstag der Anmeldung: 24.01.1996
(73) Patentinhaber: ROBERT BOSCH GMBH, 70442 Stuttgart (DE)
(72) Erfinder: Ohms, Franz, D-74420 Oberrot (DE)

(56) Entgegenhaltungen:
- DE-C- 3 843 260
- US-A- 3 182 249
- US-A- 4 275 347

## Beschreibung

Die Erfindung betrifft einen Kathodenstromregler, insbesondere für einen Wanderfeldröhrenverstärker

Aus der DE 38 43 260 C1 ist ein Kathodenstromregler für einen Wanderfeldröhrenverstärker bekannt. Der dortige Stromwandler in der Kathodenzuleitung muß für Hochspannung ausgelegt sein. Das Potential am lastseitigen Ende des Stellgliedes wird über eine Stromquelle, die vom sekundärseitigen Spannungsabfall am Stromwandler beeinflußt wird, so verstellt, daß ein vorgegebener Strom durch das Transistor-Stellglied fließt.

Aufgabe vorliegender Erfindung ist es einen Kathodenstromregler anzugeben, der zuverlässig arbeitet und einfach aufgebaut ist. Diese Aufgabe wird durch die Merkmale des Anspruchs 1 oder 2 gelöst. Die weiteren Ansprüche zeigen vorteilhafte Weiterbildungen auf.

Der Kathodenstromregler nach der Erfindung benötigt insbesondere keine zusätzlichen Einrichtungen zur Potentialtrennung, wie Optokoppler oder zusätzliche Übertrager. Durch mehr oder weniger starkes Kurzschließen der Hilfswicklung bzw. der Primärwicklung des Stromwandlers in der Kathodenzuleitung in Abhängigkeit des Kathodenstromes wird die Spannungsversorgung des Stellglied verändert, was insgesamt eine Konstantregelung des Kathodenstromes bewirkt. Bei der Realisierung gemäß Anspruch 1 wird die Ansteuerleistung des Stellgliedes durch eine Hilfsquelle aufgebracht. Demzufolge benötigt der Stromwandler in der Kathodenzuleitung nur wenig Windungen. Bei der Realisierung gemäß Anspruch 2 ist anstelle eines Übertrages mit Hilfswicklung nur ein einfacher Stromwandler notwendig.

Anhand der Zeichnungen werden Ausführungsbeispiele der Erfindung näher erläutert. Es zeigen
Figur 1 ein Prinzipschaltbild eines Kathodenstromreglers nach der Erfindung,
Figur 2 eine Variante zum Kathodenstromregler gemäß Figur 1 und
Figur 3 einen Kathodenstromregler für mehrere Kathodenströme.

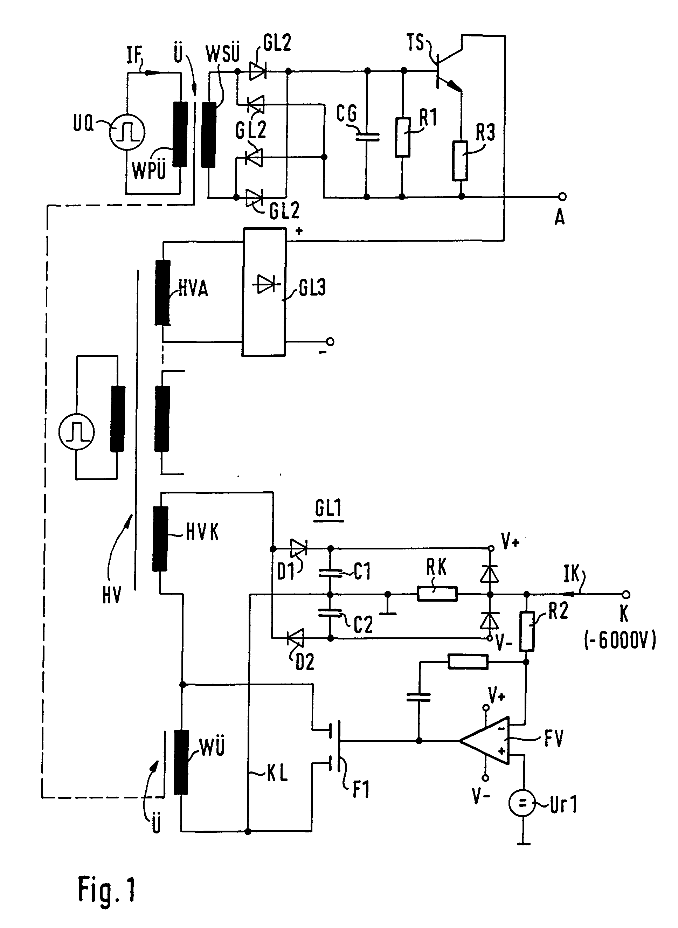

Beim Ausführungsbeispiel nach Figur 1 werden die Versorgungsspannungen für den Röhrenverstärker, insbesondere einen Wanderfeldröhrenverstärker, über einen Hochspannungstransformator HV mit mehreren Sekundärstromkreisen gewonnen.

An einer Sekundärwicklung HVK wird die Spannung für die Kathode K des Wanderfeldröhrenverstärkers, z.B. -6000 V, abgenommen. In der Kathodenzuleitung KL befindet sich vor der Gleichrichter-Schaltung Gl1 die Hilfswicklung WÜ des Übertragers Ü, der ein Strommeßwiderstand RK in Serie geschaltet ist. Über den Strommeßwiderstand RK wird ein zum Kathodenstrom IK proportionales Signal erfaßt, welches einem Fehlersignalverstärker FV über den Widerstand R2 zugeführt wird. Dieser Fehlersignalverstärker FV vergleicht das kathodenstromproportionale Signal mit einer Referenzspannung Ur1. Am Ausgang des Fehlersignalverstärkers FV erscheint ein Fehlersignal, welches einem Transistor F1, hier in Form eines MOSFET, an seinem Steueranschluß - Gate - zugeführt wird. Der Transistor F1 ist der Hilfswicklung WÜ parallel geschaltet und schließt somit je nach Höhe des Fehlersignals die Hilfswicklung WÜ mehr oder weniger kurz. Der Übertrager Ü ist primärseitig an eine Hilfsquelle UQ angeschlossen, welche die Ansteuerleistung für das Stellglied TS des Kathodenstromreglers aufbringt. Vorteilhafterweise befindet sich die Primärwicklung wpü des Übertragers Ü im Heizkreis (Heizstrom IF) oder einem Hochspannungskreis des Wanderfeldröhrenverstärker, so daß für die Aufbringung der Ansteuerleistung des Stellglieds TS keine separate Energiequelle benötigt wird. Die Sekundärwicklung wsü ist über den Gleichrichter Gl2 mit der Basis des Stellglied-Transistors TS verbunden. Der Gleichrichter Gl2 ist ausgangsseitig mit einem Glättungskondensator CG beschaltet, dem ein Widerstand R1 zur Ladestrombegrenzung parallel geschaltet ist. Der Stellglied-Transistor TS ist emitterseitig über den Widerstand R3 mit der Anode A des Wanderfeldröhrenverstärkers verbunden. Der Kollektor des Stellglied-Transistors TS ist an eine weitere Sekundärwicklung HVA des Hochspannungstransformators HV über einen Gleichrichter Gl3 angeschlossen. Die Ansteuerleistung des Stellgliedes TS wird demnach potentialgetrennt von einer Hilfsquelle UQ aufgebracht. Im Gegensatz zur Lösung gemäß DE 38 43 260 C1 muß also die Ansteuerleistung des Stellgliedes nicht über einen Stromwandler mit Belastung durch Hochspannungspotential aufgebracht werden. Der Übertrager Ü kann als Ringkernübertrager ausgebildet sein, der nur wenige Windungen einer HV-Litze trägt. Durch den Parallel-Shunt zur Hilfswicklung WÜ in Form des Transistors F1 wird die Spannungsversorgung des Stellglied-Transistors TS in Abhängigkeit des fließenden Kathodenstromes IK geregelt. Die Ansteuerleistung für das Stellglied kann auch aus der Wicklung WÜ allein aufgebracht werden. Die Hilfsquelle UQ ist dann entbehrlich.

Zur Gleichrichtung der Spannung an der Sekundärwicklung HVK ist die Gleichrichterschaltung Gl1, bestehend aus den Dioden D1, D2 mit zugehörigen Glättungskondensatoren C1, C2 vorgesehen. Über die Gleichrichterschaltung Gl1 kann auch die positive und negative Versorgungsspannung +V bzw. -V für den als Operationsverstärker ausgebildeten Fehlersignalverstärker FV abgeleitet werden.

Anstelle des Strommeßwiderstandes RK kann natürlich auch ein Strommeßwandler SW1 als Stromsensor verwendet werden.

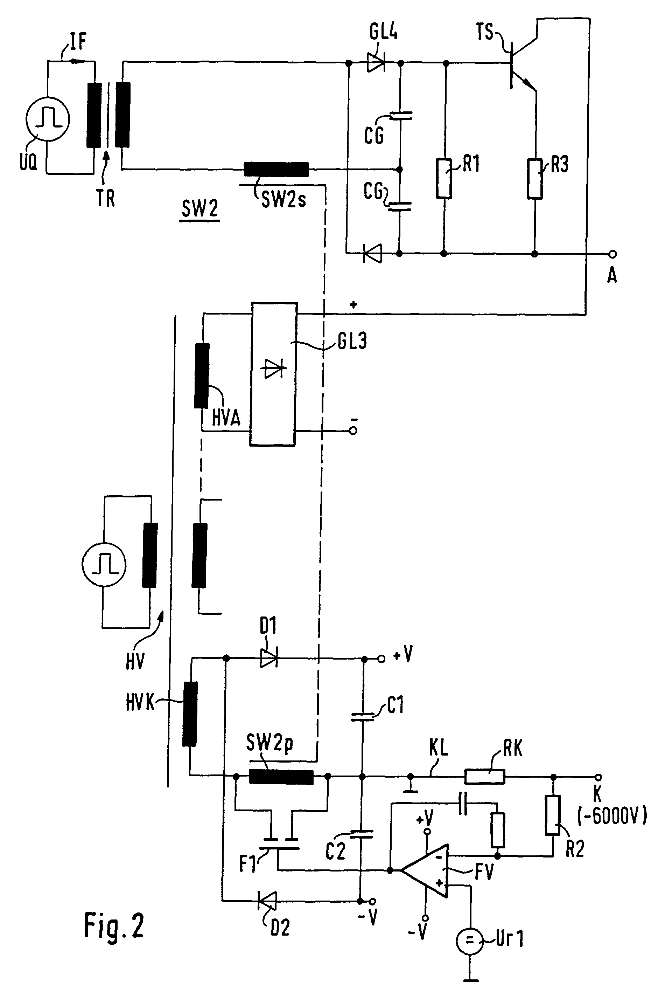

Im Ausführungsbeispiel nach Figur 2 erfolgt die Steuerung des Stellgliedes TS über einen Stromwandler SW2, dessen Primärwicklung SW2p in der Kathodenzuleitung KL und dessen Sekundärwicklung SW2s im Stromkreis für die Aufbereitung der Ansteuerleistung für das Stellglied TS angeordnet ist. Im dargestellten Beispiel befindet sich die Sekundärwicklung SW2s in einer der Zuleitungen zwischen dem Transformator TR und dem Zweiweggleichrichter Gl4. Der Transformator TR dient zur Übertragung der von der Hilfsquelle UQ aufgebrachten Ansteuerleistung des Stellglied-Transistors TS. Wie zuvor ist ein Fehlersignalverstärker FV vorgesehen, der über einen Stromsensor - Strommeßwiderstand RK oder alternativ dazu einen Strommeßwandler SW1 - das kathodenstromproportionale Signal mit der Referenzspannung Ur1 vergleicht. Das so gebildete Fehlersignal steuert den MOSFET-Transistor F1, der nun parallel zur Primärwicklung SW2p des Stromwandlers SW2 angeordnet ist. Je nach Höhe der Fehlerspannung wird die Primärwicklung SW2p mehr oder weniger kurzgeschlossen und so die Ansteuerleistung des Stellgliedes TS in Abhängigkeit des Kathodenstromes IK geregelt. Ist der MOSFET-Transistor F1 nicht durchgesteuert, wirkt die volle Impedanz der Sekundärwicklung SW2s (hochohmig). Dadurch kann keine Ansteuerleistung zum Stellglied TS gelangen. Im durchgeschalteten Zustand des MOSFET-Transistors F1 transformiert sich der Kurzschluß an der Primärwicklung SW2p auf die Sekundärseite. Damit ist die Impedanz der Sekundärwicklung SW2s niederohmig und die volle Ansteuerleistung kann zum Stellglied TS gelangen.

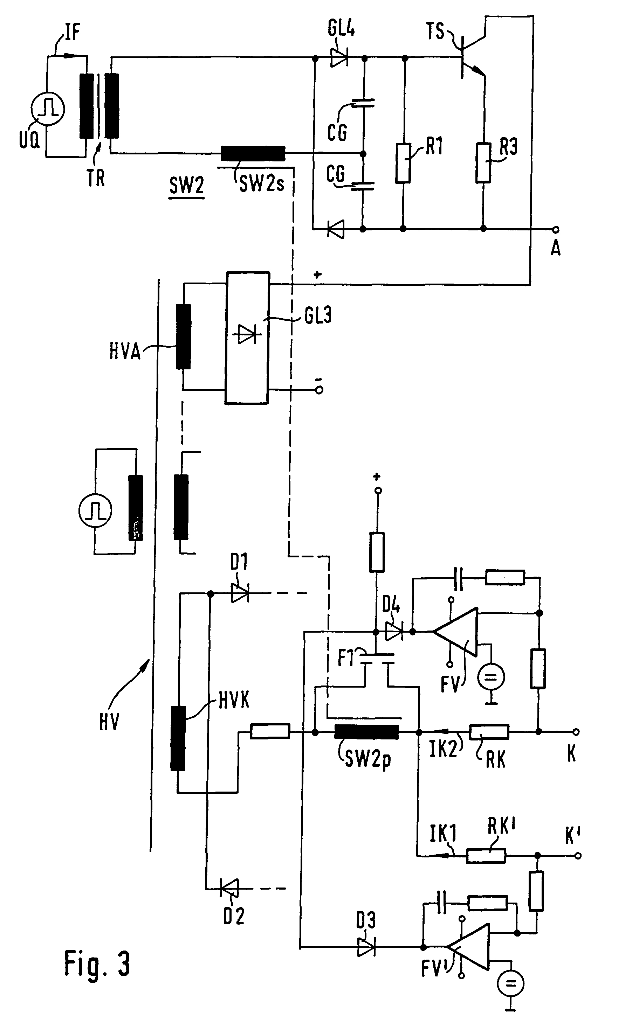

Das Ausführungsbeispiel nach Figur 3 zeigt einen Kathodenstromregler für mehrere - hier speziell für zwei - Leistungsverstärkerröhren mit den Kathoden K und K'. In jeder Kathodenstromzuleitung ist ein Stromsensor in Form eines Strommeßwandlers SW, SW1', bzw. wie dargestellt, in Form eines Strommeßwiderstandes RK, RK' vorgesehen. Zur Stromauswertung ist auch jeweils ein Fehlersignalverstärker FV bzw. FV' vorhanden. Die Ausgänge der Fehlerverstärker FV und FV' sind im Sinne einer ODER-Verknüpfung (Dioden D3, D4) verbunden und führen zum Transistor F1, der der Primärwicklung SW2p des Stromwandlers SW2 parallel geschaltet ist. Auf diese Weise wird die Ansteuerleistung des Stellglied-Transistors TS in Abhängigkeit beider Kathodenströme IK1 und IK2 geregelt. Durch diese Verknüpfung der Fehlerverstärker FV und FV' regelt immer jene Röhre - Kathode K oder K' - die Anodenspannung, welche die kleinste Spannung für einen bestimmten Kathodenstrom benötigt (Überlastschutz). Die Ansteuerleistung für das Stellglied TS wird entsprechend dem vorigen Ausführungsbeispiel über die Änderung der Impedanz der Sekundärwicklung SW2s geregelt. Die ODER-Verknüpfung der Ausgangssignale der Fehlerverstärker FV und FV' kann natürlich auch erst im Steuerkreis des Stellgliedes TS über eine Zusammenschaltung der Sekundärwicklungen zweier Stromwandler erfolgen, deren Primärwicklungen in jeweils einer der Kathodenzuleitungen angeordnet sind. Die erstere Variante spart einen Stromwandler. Die letztere Variante weist eine höhere Betriebssicherheit auf.

Optional können mehrere Steuerkreise mit entsprechenden Stellgliedern vorgesehen werden. Dies ist dann sinnvoll, wenn mehrere (zwei) Leistungsverstärkerröhren betrieben werden, die z.B. unterschiedlich altern (durch Betriebsweise, z.B. redundante Reserveröhre). Dadurch können die Anodenspannungen unterschiedlich eingeregelt werden bei jeweiligem konstanten Kathodenstrom.

Natürlich läßt sich die Schaltung gemäß Figur 1 in ähnlicher Weise für die Erfassung mehrerer Kathodenströme ergänzen, z.B. durch einen weiteren Stromsensor mit zugehörigem Fehlerverstärker und einer weiteren Hilfswicklung auf dem Übertrager Ü.

Die Primärwicklung/en des Stromwandlers SW2 kann/können ebenfalls als HV-Litze mit 1 bis 5 Windungen auf einem Ringkern angeordnet werden.

## Patentansprüche

1. Kathodenstromregler, insbesondere für einen Wanderfeldröhrenverstärker, mit folgenden Baugruppen:
- einem Stromsensor (SW1, RK) in der Kathodenzuleitung zur Aufbereitung eines stromproportionalen Signals,
- einem Fehlersignalverstärker (FV) für das stromproportionale Signal,
- einer Hilfsquelle (UQ) oder einer Hilfswicklung (WÜ), welche über einen Übertrager (Ü) die Ansteuerleistung für das Stellglied (TS) des Kathodenstromreglers aufbringt,
- einer Hilfswicklung (WÜ) auf dem Übertrager (Ü), welche derart mit dem Fehlersignalverstärker (FV) verbunden ist, daß die Spannungsversorgung des Stellgliedes (TS) in Abhängigkeit des Kathodenstromes (IK) regelbar ist.

2. Kathodenstromregler, insbesondere für einen Wanderfeldröhrenverstärker, mit folgenden Baugruppen:
- einem Stromsensor (SW1, RK) in der Kathodenzuleitung zur Aufbereitung eines stromproportionalen Signals,
- einem Stromwandler (SW2), dessen Primärwicklung (SW2p) in der Kathodenzuleitung angeordnet ist und dessen Sekundärwicklung (SW2s) mit dem Stellglied (TS) zu dessen Spannungsversorgung verbunden ist,
- einem Fehlersignalverstärker (FV) für das stromproportionale Signal, welcher derart mit der Primärwicklung (SW2p) des Stromwandlers (SW2) verbunden ist, daß die Spannungsversorgung des Stellgliedes (TS) in Abhängigkeit des Kathodenstromes (IK) regelbar ist.

3. Kathodenstromregler nach Anspruch 1 oder 2, **dadurch gekennzeichnet, daß** der Hilfswicklung (WÜ) bzw. der Primärwicklung (SW2p) des Stromwandlers (SW2) ein Transistor (F1) parallel geschaltet ist, dessen Steuerelektrode mit dem Ausgang des Fehlersignalverstärkers (FV) in Wirkverbindung steht.

4. Kathodenstromregler nach Anspruch 1 oder 3, **dadurch gekennzeichnet, daß** der Übertrager (Ü) mit dem Heizkreis oder einem Hochspannungskreis des Röhrenverstärkers zur Aufbringung der Ansteuerleistung für das Stellglied (TS) des Kathodenstromreglers gekoppelt ist.

5. Kathodenstromregler nach einem der Ansprüche 1 bis 4, **dadurch gekennzeichnet, daß** bei mehreren Kathodenstromzuleitungen ein Stromsensor (SW1, SW1', RK, RK') in mindestens zwei dieser Zuleitungen angeordnet ist, daß den Stromsensoren jeweils ein Fehlerverstärker (FV, FV') zugeordnet ist und daß Mittel zur Verknüpfung der Ausgangssignale der Fehlerverstärker (FV, FV') vorgesehen sind derart, daß die Spannungsversorgung des Stellgliedes (TS) in Abhängigkeit der über Stromsensoren erfaßten Kathodenströme (IK1, IK2) regelbar ist.

## Claims

1. Cathode current regulator, in particular for a travelling-wave tube amplifier, having the following assemblies:
- a current sensor (SW1, RK) in the cathode lead for conditioning a current-proportional signal,
- an error signal amplifier (FV) for the current-proportional signal,
- an auxiliary source (UQ) or an auxiliary winding (WÜ), which applies the drive power for the actuator (TS) of the cathode current regulator via a transformer (Ü),
- an auxiliary winding (WÜ) on the transformer (Ü), which winding is connected to the error signal amplifier (FV) in such a way that the voltage supply of the actuator (TS) can be regulated as a function of the cathode current (IK).

2. Cathode current regulator, in particular for a travelling-wave tube amplifier, having the following assemblies:
- a current sensor (SW1, RK) in the cathode lead for conditioning a current-proportional signal,
- a current transformer (SW2), whose primary winding (SW2p) is arranged in the cathode lead and whose secondary winding (SW2s) is connected to the actuator (TS) in order to supply voltage to the latter,
- an error signal amplifier (FV) for the current-proportional signal, which amplifier is connected to the primary winding (SW2p) of the current transformer (SW2) in such a way that the voltage supply of the actuator (TS) can be regulated as a function of the cathode current (IK).

3. Cathode current regulator according to Claim 1 or 2, **characterized in that** a transistor (F1) is connected in parallel with the auxiliary winding (WÜ) or the primary winding (SW2p) of the current transformer (SW2), the control electrode of which transistor is operatively connected to the output of the error signal amplifier (FV).

4. Cathode current regulator according to Claim 1 or 3, **characterized in that** the transformer (U) is coupled to the heating circuit or a high-voltage circuit of the tube amplifier for the purpose of applying the drive power for the actuator (TS) of the cathode current regulator.

5. Cathode current regulator according to one of Claims 1 to 4, **characterized in that** when there are a plurality of cathode current leads, a current sensor (SW1, SW1', RK, RK') is arranged in at least two of these leads, **in that** the current sensors are each assigned an error amplifier (FV, FV'), and **in that** means for combining the output signals of the error amplifiers (FV, FV') are provided in such a way that the voltage supply of the actuator (TS) can be regulated as a function of the cathode currents (IK1, IK2) detected by means of current sensors.

## Revendications

1. Régulateur de courant cathodique notamment pour un amplificateur de tube à ondes progressives comprenant les ensembles suivants :
- un capteur d'intensité (SW1, RK) installé dans la ligne d'alimentation de la cathode pour développer un signal proportionnel à l'intensité,
- un amplificateur de signal d'erreur (FV) pour le signal proportionnel à l'intensité,
- une source auxiliaire (UQ) ou un enroulement auxiliaire (WÜ) qui applique la puissance de commande de l'actionneur (TS) du régulateur d'intensité cathodique par l'intermédiaire d'un transformateur (Ü),
- un enroulement auxiliaire (WÜ) du transformateur (Ü), relié à l'amplificateur de signal d'erreur (FV) pour que l'alimentation en tension de l'actionneur (TS) se règle en fonction de l'intensité cathodique (IK).

2. Régulateur de courant cathodique notamment pour un amplificateur de tube à ondes progressives, comprenant les ensembles suivants :
- un capteur d'intensité (SW1, RK) installé dans la ligne d'alimentation de la cathode pour développer un signal proportionnel à l'intensité,
- un transformateur de courant (SW2) dont le primaire (SW2p) est placé dans la ligne d'alimentation de la cathode et dont le secondaire (SW2s) est relié à l'actionneur (TS) pour en assurer l'alimentation en tension,
- un amplificateur de signal d'erreur (FV) pour le signal proportionnel à l'intensité, cet amplificateur étant relié au primaire (SW2p) du transformateur de courant (SW1) pour que l'alimentation en tension de l'actionneur (TS) puisse se régler en fonction du courant cathodique (IK).

3. Régulateur de courant cathodique selon la revendication 1 ou 2,
**caractérisé en ce que**
l'enroulement auxiliaire (WÜ) ou l'enroulement primaire (SW2p) du transformateur de courant (SW2) comporte un transistor (F1) branché en parallèle, dont l'électrode de commande est reliée à la sortie de l'amplificateur de signal d'erreur (FV) pour coopérer.

4. Régulateur de courant cathodique selon la revendication 1 ou 3,
**caractérisé en ce que**
le transformateur (Ü) est couplé au circuit de chauffage ou au circuit de haute tension de l'amplificateur de tube à ondes progressives pour appliquer la puissance de commande à l'actionneur (TS) du régulateur de courant cathodique.

5. Régulateur de courant cathodique selon l'une quelconque des revendications 1 à 4,
**caractérisé par**
- un capteur de courant (SW1, SW1', RK, RK') prévu dans au moins deux des lignes pour plusieurs lignes d'alimentation cathodiques,
- un amplificateur d'erreur (FV, FV') associé à chaque capteur d'intensité, et
- des moyens assurant la combinaison des signaux de sortie des amplificateurs d'erreur (FV, FV') de façon à réguler la tension d'alimentation de l'actionneur (TS) en fonction des courants cathodiques (IK1, IK2) détectés par les capteurs d'intensité.
